# EUROPEAN PATENT APPLICATION

(11) **EP 0 791 836 A1**
(43) Date of publication of application: **27.08.1997**
(21) Application number: 97300807.1
(22) Date of filing: 07.02.1997
(51) Int. Cl.: G01R 31/3185, G06F 11/00

(54) **Electronic assembly identification device**

(30) Priority: 20.02.1996 GB 9603528
(71) Applicant: INTERNATIONAL COMPUTERS LIMITED, Putney, London, SW15 1SW (GB)
(72) Inventor: Collins, David Fausto, Swinton, Manchester M27 9PN (GB); McKinstry, Adrian Albert, Pennington, Leigh WN7 3LP (GB)
(74) Representative: Guyatt, Derek Charles

(57) **Abstract**

Electronic apparatus comprises at least one sub-assembly, such as a printed circuit board. The sub-assembly includes physically modifiable storage, such as a set of switches or jumper connections, for storing information on the sub-assembly (e.g. type, version number, and modification level). The physically modifiable storage has connections which allow information to be read electronically from the sub-assembly, e.g. by shifting it serially over a shift path.

## Description

### Background to the Invention

This invention relates to electronic apparatus of the kind comprising a number of sub-assemblies, such as printed circuit boards (PCBs).

In such apparatus, it may be required to supply some unit, such as a system support processor, with information on the characteristics of each sub-assembly in the system (e.g. the type, serial number, version number, and modification level of each PCB). However, a problem with this is that of ensuring that this information is kept up-to-date, when the sub-assemblies are modified or exchanged.

The object of this invention is to provide a way of reducing or overcoming this problem.

### Summary of the Invention

According to the invention there is provided an electronic apparatus comprising at least one sub-assembly, wherein said sub-assembly includes physically modifiable storage means for storing information indicating the characteristics of said sub-assembly, and means for permitting said information to be read electronically from the sub-assembly.

### Brief Description of the Drawings

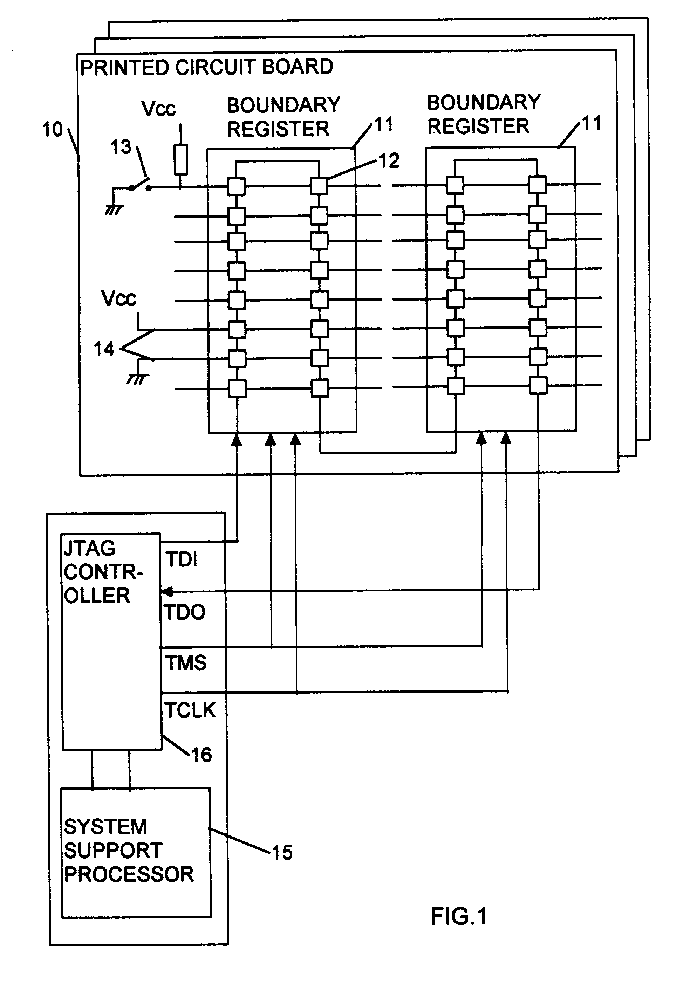

Figure 1 is a block diagram of an electronic system embodying the invention.

### Description of an Embodiment of the Invention

One embodiment of the invention will now be described by way of example with reference to the accompanying drawings.

The present invention makes use of a standard, known as JTAG (Joint Test Action Group), which is based on the IEEE 1149.1 standard. JTAG provides a standard serial interface for diagnostic and monitoring operations. The JTAG interface includes four signal lines as follows:
TDI test data in
TDO test data out
TMS test mode select
TCLK test clock

Referring to Figure 1, this shows an electronic system (e.g. a computer system) comprising a number of PCBs 10. The exact nature and function of the PCBs forms no part of the present invention, and so will not be described in any detail.

Each PCB includes a number of standard JTAG boundary scan registers 11, each of which comprises a plurality of register cells 12, connected together in series to form a serial shift register, extending between a test data input TDI and a test data output TDO.

Each PCB also includes a set of miniature switches 13, which can be manually set (e.g. by an assembly engineer or service engineer), to specify variable information relating to the PCB. For example, this information may include part number, version number and modification level. The state of each switch represents a bit value: for example, the open state may represent "0" and the closed state may represent "1". The switches are connected as shown to the data inputs of respective cells of one of the boundary scan registers.

Each PCB may also include a number of hard-wired links 14 which specify fixed information relating to the PCB. For example, this information may include the board type. Each link represents a bit value: for example, a link tied to ground may represent "0" and a link tied to supply voltage line Vcc may represent "1". These links are connected to the data inputs of respective cells of one of the boundary scan registers.

The system also includes a system support processor 15, whose function is to monitor the operation of the rest of the system, and to diagnose faults. The support processor is connected to each of the PCBs by means of a standard JTAG interface 16.

In operation, the support processor can, when required, obtain information about any PCB, by shifting the information out of the appropriate boundary scan register via the JTAG interface.

It can be seen that the arrangement described above provides a number of advantages. First, because the JTAG interface requires just four lines, it thus avoids the need for a wide parallel interface between each of the PCBs and the support processor. Moreover, it allows the PCB information to be read without the need to remove the PCB. Furthermore, it allows the PCB information to be read remotely.

### Some possible modifications

It will be appreciated that many modifications may be made to the system described above without departing from the scope of the present invention.

For example, the miniature switches may be replaced by manually settable jumper connections. Other forms of physically modifiable device could also be used, such as hexadecimal rotary switches.

Another possible embodiment of the invention may include a combined module, comprising a JTAG buffer with a physically modifiable device on top.

It will be appreciated that the invention is not limited to the use of JTAG; for example, other forms of serial interface could be used.

Another possible modification is as follows. There exist semiconductor devices that have numbers fixed into them during their manufacture. These numbers are generally used as serial numbers, and can be guaranteed by the manufacturer to be unique. Such devices could be directly or indirectly connected into the same boundary scan loop as the physically modifiable devices described above, to provide fixed information.

## Claims

1. Electronic apparatus comprising at least one sub-assembly, wherein said sub-assembly includes physically modifiable storage means for storing information indicating the characteristics of said sub-assembly, and means for permitting said information to be read electronically from the sub-assembly.

2. Apparatus according to Claim 1 wherein the sub-assembly comprises a plurality of registers connected in series in a shift path, allowing data to be shifted serially out of the sub-assembly via said shift path, and means for writing said information from the storage means into the registers in said shift path, to allow said information to be shifted serially out of the sub-assembly via said shift path.

3. Apparatus according to Claim 1 or 2 wherein said physically modifiable storage means is manually modifiable.

4. Apparatus according to Claim 3 wherein said physically modifiable storage means comprises a set of switches.

5. Apparatus according to Claim 3 wherein said physically modifiable storage means comprises a set of jumper connections.

6. Apparatus according to any preceding claim wherein said sub-assembly comprises a printed circuit board.

7. Apparatus according to Claim 6 wherein said information comprises information indicating the type, version number and modification level of said printed circuit board.

8. Apparatus according to Claim 6 or 7 wherein said information comprises information indicating the serial number of said printed circuit board.
